# EUROPEAN PATENT APPLICATION

(11) **EP 1 809 082 A1**
(43) Date of publication of application: **18.07.2007**
(21) Application number: 05787941.3
(22) Date of filing: 27.09.2005
(51) Int. Cl.: H05H 1/24, B01J 19/00, H01T 23/00

(54) **GAS EXCITATION DEVICE HAVING INSULATION FILM LAYER CARRYING ELECTRODE AND GAS EXCITATION METHOD**

(30) Priority: 28.09.2004 JP 2004282186
(71) Applicant: NITTETSU MINING CO., LTD., Tokyo 100-8377 (JP)
(72) Inventor: OTAKA, Hitoshi, machi, Nishitama-gun, Tokyo 1900182; (JP); KAWAKITA, Takayuki, machi, Nishitama-gun, Tokyo 1900182; (JP)
(74) Representative: Cohausz & Florack
(86) International application number: PCT/JP2005/017698
(87) International publication number: WO 2006/035744

(57) **Abstract**

An apparatus for exciting a gas, comprising at least one pair of electrodes connecting with an alternate current electric source in a housing having an inlet opening for the gas to be treated and an outlet opening for a treated gas, the pair being a combination of a protected electrode and a protected electrode, or a combination of a protected electrode and an exposed electrode, wherein at least one protected electrode is composed of a core electrode with an insulating coating layer carried thereon and covering an entire surface thereof is disclosed.

## Description

### TECHNICAL FIELD

The present invention relates to a gas-exciting apparatus having an electrode containing an insulating coating layer, and a gas exciting process. According to the present invention, wherein the protected electrode in the conventional gas-exciting apparatus and process is replaced with the electrode containing an insulating coating layer, a gas-excitation efficiency can be enhanced, and production and running costs can be reduced.

### BACKGROUND ART

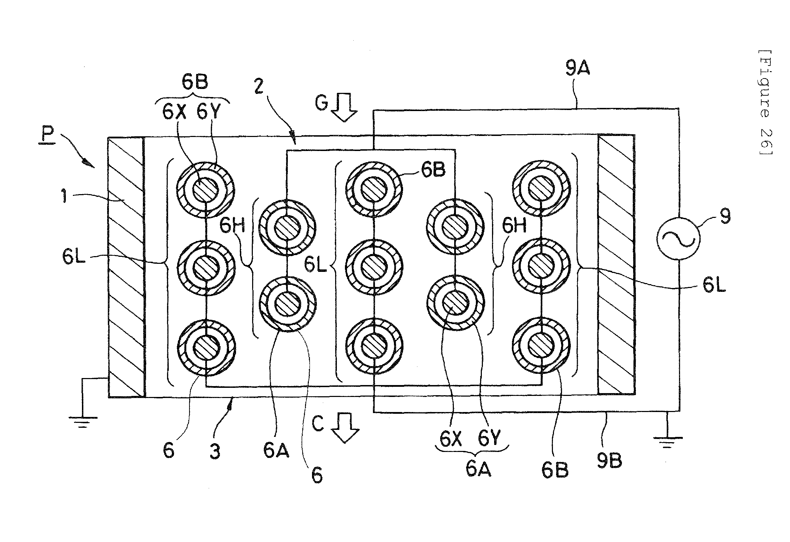

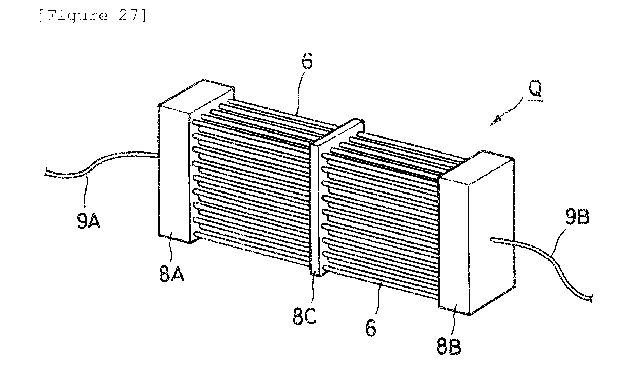

Various apparatuses are known as a gas-exciting apparatus guiding gas under an AC high-voltage discharge condition to excite gas molecules and generate a low-temperature plasma (for example, Patent Reference No. 1 or Patent Reference No. 2). A typical embodiment of the known conventional gas-exciting apparatus is illustrated in Fig. 25. Fig. 25 is a schematical perspective view of the gas-exciting apparatus P wherein a part of a sidewall of the housing 1 is cut away. The gas-exciting apparatus P contains a generally rectangular parallelepiped housing 1 having an inlet opening 2 for the gas G to be treated and an outlet opening 3 for a treated gas C. In the housing 1, there are many hollow-cylindrical protected electrodes 6. The hollow-cylindrical protected electrode 6 comprises the bar electrode 6X and the surrounding hollow-cylindrical sheath 6Y, as shown in Fig. 26, which is a schematical sectional view thereof. The hollow-cylindrical sheath 6Y is made of an insulating material. The hollow-cylindrical protected electrodes 6 are divided into two groups, the electrodes-groups 6A, 6B, each of which is connected with the electric cables 9A, 9B, respectively. The electric cables 9A, 9B connect with the AC source 9. In general, the electric cable 9B connecting with one group, the electrodes-group 6B, is grounded. In the housing 1, as shown in Fig. 26, each protected electrode 6B arranged in the outermost positions and directly opposing the inner wall of the housing 1 preferably connects with the grounded electric cable 9B to inhibit discharge between the inner wall of the housing 1 and each protected electrode 6B. It is not necessary in principle, but preferable from a safety point of view, to ground the housing 1 per se or the electrodes-group 6B.

Figs. 25 and 26 are the views for illustrating the structure of the electrodes-arrangement in a typical embodiment of the conventional gas-exciting apparatus, and thus, the structures are simplified, for example, the number of the electrodes illustrated is extremely reduced. It is, in fact, necessary to provide a large number of electrodes in the gas-exciting apparatus. Thus, as shown in Fig. 27, an electrodes-block Q containing a certain number of electrodes is assembled and plural blocks Q are positioned in the gas-exciting apparatus. The electrodes-block Q shown in Fig. 27 comprises the hollow-cylindrical protected electrodes 6, the left side plate 8A, the right side plate 8B, the central supporting plate 8C, and the lead wires 9A, 9B. The hollow-cylindrical protected electrodes 6 are supported not only by introducing them into through-holes in the central supporting plate 8C placed in the middle between the left side plate 8A and the right side plate 8B, but also by inserting each end into a non-through-hole on each of the inner walls of the left side plate 8A and the right side plate 8B.

A deodorizing apparatus or an air cleaning apparatus using a low-temperature non-equilibrium plasma generated by the gas-exciting apparatus is also known. For example, a deodorizing apparatus using a low-temperature plasma deodorizing apparatus, comprising a high-voltage discharging means for generating a low-temperature plasma and a catalyzing means positioned downstream thereof, is known (Patent Reference No. 3). In the high-voltage discharging means, radicals are generated by applying a dissociation energy by a high-voltage discharge to the gas to be treated. It is believed that electrons emitted into the gas by the discharge are bombarded to gaseous molecules in the odor gas to thereby activate the molecules, and a part of the activated molecules is dissociated to become radicals, which in turn oxidize or decompose malodorous substances in the odor gas or generate ozone. Further, it is believed that ozone generated by the radicals oxidizes malodorous substances to thereby contribute to the treatment of the malodorous substances. The energy per se for the discharge may oxidize or decompose the malodorous substances.

[Patent Reference No. 1] Japanese Unexamined Patent Publication (Kokai) No. 9-199261;
[Patent Reference No. 2] U.S. Patent No. 5,483,117;
[Patent Reference No. 3] Japanese Unexamined Patent Publication (Kokai) No. 2001-293079.

### DISCLOSURE OF INVENTION

### PROBLEMS TO BE SOLVED BY THE INVENTION

As explained, the hollow-cylindrical protected electrode 6 used in the conventional gas-exciting apparatus P as shown in Figs. 25 and 26 comprises the bar electrode 6X and the surrounding hollow-cylindrical sheath 6Y. Generally, a metal bar electrode is used as the bar electrode 6X, and a glass tube is used as the hollow-cylindrical sheath 6Y. Such a hollow-cylindrical protected electrode 6 is produced by inserting the metal bar electrode 6X into the glass sheath 6Y, and thus an air space exists between the glass sheath 6Y and the metal bar electrode 6X. The bar electrode 6X is surrounded by the hollow-cylindrical sheath 6Y via the air space. Therefore, the conventional protected electrode has a disadvantage in that a discharge is generated in the inside thereof, and thus the metal electrode is considerably deteriorated. Many component parts are necessary, and the production or assembly is troublesome and leads to high costs. Further, in the conventional protected electrode, the glass tube having an inside space is exposed, and thus it is necessary to carefully assemble the electrodes-block Q to prevent the glass tube from breaking.
Furthermore, it is always desirable for a gas-exciting apparatus to enhance a gas-excitation efficiency.
Accordingly, the problem to be solved by the present invention is to enhance a gas-excitation efficiency, and remedy the disadvantages of the conventional protected electrode.

### MEANS FOR SOLVING THE PROBLEMS

The problems shown above can be solved by an apparatus for exciting a gas according to the present invention, comprising at least one pair of electrodes connecting with an alternate current electric source in a housing having an inlet opening for the gas to be treated and an outlet opening for a treated gas, the pair being a combination of a protected electrode and a protected electrode, or a combination of a protected electrode and an exposed electrode, wherein at least one protected electrode is composed of a core electrode with an insulating coating layer carried thereon and covering an entire surface thereof.
According to a preferred embodiment of the present apparatus, the insulating coating layer is a porcelain enameled coating layer, a ceramic coating layer, a glass coating layer, or a resin coating layer.
According to another preferred embodiment of the present apparatus, the apparatus comprises a first electrodes-group composed of plural protected electrodes and a second electrodes-group composed of plural protected or exposed electrodes, and at least one of the protected electrodes belonging to the first electrodes-group and/or the protected electrodes belonging to the second electrodes-group is the protected electrode containing the insulating coating layer. According to still another preferred embodiment of the present apparatus, all of the protected electrodes are the protected electrode containing the insulating coating layer.
According to still another preferred embodiment of the present apparatus, the core electrode carrying the insulating coating layer thereon in the protected electrode is in a solid-cylindrical form, a hollow-cylindrical form, or a plate form.
According to still another preferred embodiment of the present apparatus, the inner plate electrode is a plate electrode, a concave-convex plate electrode, or a perforated plate electrode.
The present invention also relates to a process for exciting a gas, comprising passing the gas to be treated into a housing containing at least one pair of electrodes and having an inlet opening for the gas to be treated and an outlet opening for a treated gas, the pair being a combination of a protected electrode and a protected electrode, or a combination of a protected electrode and an exposed electrode, and applying an alternating-current potential between the pair of electrodes to excite the gas to be treated,
wherein at least one protected electrode is composed of a core electrode with an insulating coating layer carried thereon and covering an entire surface thereof.

### EFFECTS OF THE INVENTION

In the present invention, the protected electrode is composed of
(a) a core electrode, and
(b) an insulating coating layer,
   and the insulating coating layer (b) is formed directly on the surface of the core electrode (a), and thus is different from the conventional protected electrode in that the insulating coating layer (b) is in close contact with the metal bar electrode (a), and an air space does not exist therebetween. Therefore, a deterioration of the metal electrode with ozone generated by the inside discharge does not occur, and a lifetime of the protected electrode is extended. Because ozone is not generated by an inside discharge, a gas-excitation efficiency is enhanced. Because an air space does not exist between the core electrode (a) and the insulating coating layer (b), the size of the protected electrode can be made thinner than the conventional size, and therefore, a gas-exciting apparatus or the electrodes-block (see Fig. 27) occupying a smaller space can be produced.
   Further, the insulating coating layer (b) can be formed, for example, by baking a vitreous glaze on the surface of the metal electrode to form a porcelain enameled coating layer, by spraying a molten metallic compound onto the electrode surface or dipping the electrode surface with a molten metallic compound to form a ceramic coating layer, by spraying a molten glass or dipping with a molten glass to form a glass coating layer, or by using various known molding methods to form a resin coating layer from a synthetic resin. Further, the insulating coating layer can be produced by adhering a ceramic coat, a glass coat (such as a glass plate), or a resin coat which has been formed in advance onto the electrode surface with an adhesive. Therefore, cumbersome production procedures can be avoided, and breakages become fewer due to an enhanced strength, whereby the gas-exciting apparatus and the electrodes-block can be easily assembled.

### BRIEF DESCRIPTION OF THE DRAWINGS

[Fig. 1(a)] A schematic sectional view illustrating an elemental structure of electrodes in a conventional protected/protected-electrodes-apparatus.
[Fig. 1(b)] A schematic sectional view illustrating an elemental structure of electrodes in a protected/protected-electrodes-apparatus according to the present invention.
[Fig. 2(a)] A schematic sectional view illustrating an elemental structure of electrodes in a conventional protected/exposed-electrodes-apparatus.
[Fig. 2(b)] A schematic sectional view illustrating an elemental structure of electrodes in a protected/exposed-electrodes-apparatus according to the present invention.
[Fig. 3] A schematic perspective view of the apparatus according to the present invention wherein a part of the side wall of the housing is cut away.
[Fig. 4] A schematic sectional view of the apparatus according to the present invention shown in Fig. 3.
[Fig. 5] A schematic perspective view of the apparatus according to the present invention wherein a part of the side wall of the housing is cut away.
[Fig. 6] A schematic sectional view of the apparatus according to the present invention shown in Fig. 5.
[Fig. 7] A perspective view of a plate electrode which may be used in the present invention.
[Fig. 8] A perspective view of another plate electrode which may be used in the present invention.
[Fig. 9] A perspective view of a concave-convex plate electrode which may be used in the present invention.
[Fig. 10] A perspective view of another concave-convex plate electrode which may be used in the present invention.
[Fig. 11] A perspective view of still another concave-convex plate electrode which may be used in the present invention.
[Fig. 12] A perspective view of still another concave-convex plate electrode which may be used in the present invention.
[Fig. 13] A perspective view of a plate electrode with through-holes which may be used in the present invention.
[Fig. 14] A schematic sectional view illustrating an elemental structure of electrodes in the present apparatus shown in Fig. 3.
[Fig. 15] A schematic sectional view illustrating an elemental structure of electrodes in the present apparatus shown in Fig. 5.
[Fig. 16] A schematic sectional view illustrating an elemental structure of electrodes in another embodiment of the present apparatus.
[Fig. 17] A schematic sectional view illustrating an elemental structure of electrodes in still another embodiment of the present apparatus.
[Fig. 18] A schematic sectional view illustrating an elemental structure of electrodes in still another embodiment of the present apparatus.
[Fig. 19] A schematic sectional view illustrating an elemental structure of electrodes in still another embodiment of the present apparatus.
[Fig. 20] A schematic perspective view of an exposed electrode having rectangular parallelepiped sheaths for preventing surface discharge.
[Fig. 21] A schematic sectional view illustrating an elemental structure of an exposed electrode having hollow-cylindrical sheaths for preventing surface discharge.
[Fig. 22] A schematic perspective view of the present apparatus using exposed plate electrodes wherein a part of the side wall of the housing is cut away.
[Fig. 23] A schematic sectional view of the present apparatus shown in Fig. 22.
[Fig. 24] A schematic perspective view of an exposed plate electrode surrounded by a sheath for preventing surface discharge.
[Fig. 25] A schematic perspective view of a conventional gas-treating apparatus wherein a part of the side wall of the housing is cut away.
[Fig. 26] A schematic sectional view of a conventional gas-treating apparatus shown in Fig. 16.
[Fig. 27] A schematic perspective view of an electrodes-block used in a conventional gas-treating apparatus.

### EXPLANATION OF NUMERICAL REFERENCES

1, 11, 21, 31, 41, 51, 61, 71, 101 ... housing;
2, 12, 22, 32, 42, 52, 62, 72, 102 ... inlet opening;
3, 13, 23, 33, 43, 53, 63, 73, 103 ... outlet opening;
5 ... exposed plate electrode;
5A ... exposed end;
6 ... hollow-cylindrical protected electrode;
6A, 6B ... electrodes-group;
6L ... first electrodes-group;
6H ... second electrodes-group;
6X, 16X, 76X ... bar electrode (metal bar electrode);
6Y,16Y ... hollow-cylindrical sheath (glass sheath);
62, 162 ... space;
7 ... hollow-cylindrical exposed electrode;
67B ... hollow/solid-cylindrical exposed electrode;
8A ... left side plate; 8B ... right side plate;
8C ... central supporting plate;
9, 19, 29, 39, 49, 59, 69 ··· AC source;
9A, 9B, 19A, 19B, 29A, 29B, 39A, 39B, 49A, 49B, 59A, 59B, 69A, 69B ... wire;
10, 20, 70 ... apparatus of the present invention;
10A, 30 ... protected/protected-electrodes-apparatus;
10B ... protected/exposed-electrodes-apparatus;
14B, 24A, 24B, 34B, 54A, 64A ... protected plate electrode;
14X, 24X, 34X, 54X, 64X ··· inner plate electrode;
14Y, 24Y, 34Y, 54Y, 64Y ... insulating coating layer;
16A ... hollow-cylindrical protected electrode;
34A, 46A, 76A ... solid-cylindrical protected electrode;
40, 50, 60 ··· protected/exposed-electrodes-apparatus;
45B, 55B, 75B ... exposed plate electrode;
46X, 76X ... inner bar electrode;
46Y, 76Y ... insulating coating layer;
60Z ... sheath;
106A, 106B ... solid-cylindrical protected electrode;
106X ... inner bar electrode;
106Y ... insulating coating layer;
107B ... hollow-cylindrical exposed electrode;
109 ... AC source; 109A, 109B ... wire;
310, 320 ... plate electrode;
310a, 330a, 340a ... flat surface;
320a ... rounded surface;
330, 340, 350, 360 ... concave-convex plate electrode;
341 ... regular hexahedron depressed portion;
350a, 360a ... zonal groove;
350b, 360b ... zonal projection;
370 ... perforated plate electrode; 370a ... hole;
C ... treated gas; G ··· gas to be treated;
P ... gas-exciting apparatus (conventional apparatus);
P1 ... protected/protected-electrodes-apparatus;
P2 ... protected/exposed-electrodes-apparatus;
Q ··· block.

### BEST MODE FOR CARRYING OUT THE INVENTION

The apparatus of the present invention contains at least one pair of electrodes, as in the conventional apparatus, but the pair of the electrodes is
(1) a combination of a protected electrode and a protected electrode, or
(2) a combination of a protected electrode and an exposed electrode.
   Hereinafter, the embodiment of the combination (1) as above will be referred to as a protected/protected-electrodes-apparatus, and the embodiment of the combination (2) as above will be referred to as a protected/exposed-electrodes-apparatus.

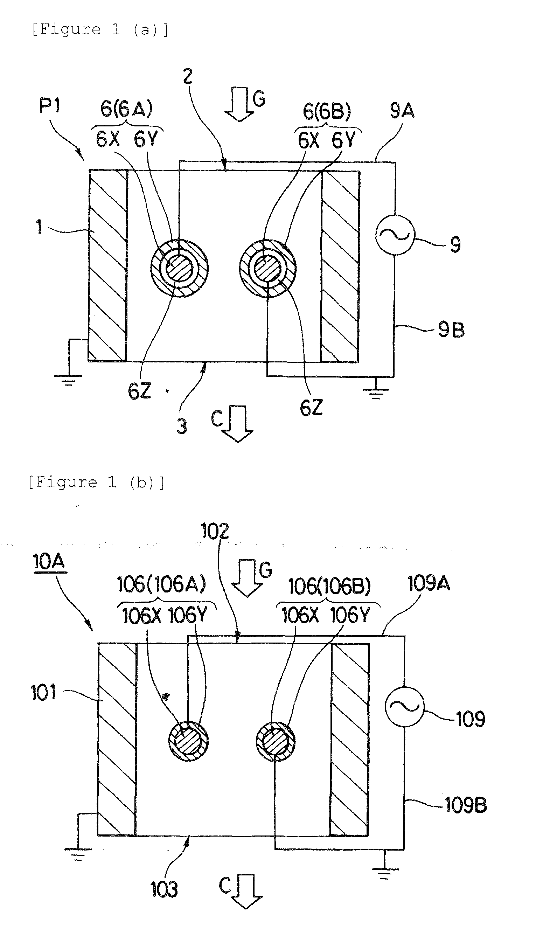

Fig. 1(a) is a schematic sectional view illustrating an elemental structure of electrodes in the conventional protected/protected-electrodes-apparatus P1, and Fig. 1(b) is a schematic sectional view illustrating an elemental structure of electrodes in a protected/protected-electrodes-apparatus 10A which is an embodiment according to the present invention.
The conventional apparatus P1 shown in Fig. 1(a) comprises the housing 1 having the inlet opening 2 for the gas G to be treated and the outlet opening 3 for the treated gas C. A pair of the hollow-cylindrical protected electrodes 6A, 6B is provided inside the housing 1. Each of the hollow-cylindrical protected electrodes 6A, 6B contains the inner bar electrode 6X and the hollow-cylindrical sheath 6Y. The hollow-cylindrical sheath 6Y is generally a glass tube, and surrounds the inner bar electrode 6X via the space 6Z. The hollow-cylindrical protected electrode 6A is connected with the electric cable 9A, and the hollow-cylindrical protected electrode 6B is connected with the electric cable 9B. The electric cables 9A, 9B are connected with the AC source 9, respectively. It is not necessary to ground the wire and the housing. However, one or both the wire and the housing may be grounded. In the embodiment shown in Fig. 1(a), both the housing 1 and the electric cable 9B are grounded.

The inner bar electrode 6X in the hollow-cylindrical protected electrodes 6A, 6B used in the conventional apparatus P1 is made of an electrically conductive material, such as aluminum or an alloy thereof, copper, carbonaceous material, iron or an alloy thereof, or tungsten. Generally, the inner bar electrode 16X is in a bar form (for example, a hollow-cylindrical form or a solid-cylindrical form), or a conductive wire per se or a twisted-wires-electrode prepared by twisting conductive wires. The hollow-cylindrical sheath 6Y is made of an insulating material (generally glass as above), and air or an appropriate protective gas or liquid (such as oil or water) is filled in the space 6Z between the glass tube sheath 6Y and the inner bar electrode 6X.

On the contrary, the present protected/protected-electrodes-apparatus 10A shown in Fig. 1(b) comprises the housing 101 having the inlet opening 102 for the gas G to be treated and the outlet opening 103 for the treated gas C. A pair of the solid-cylindrical protected electrode 106A, 106B is provided in the housing 101. Each of the solid-cylindrical protected electrodes 106A, 106B contains the inner bar electrode 106X and the insulating coating layer 106Y, respectively. The insulating coating layer 106Y is carried on the inner bar electrode 106X in such a manner that the insulating coating layer 106Y is in close contact with the inner bar electrode 106X and covers the entire surface of the inner bar electrode 106X. Therefore, there is no space between the inner bar electrode 106X and the insulating coating layer 106Y. The gas to be treated is brought into contact with the insulating coating layer 106Y, but is not brought into contact with the inner bar electrode 106X. The solid-cylindrical protected electrode 106A is connected with the wire 109A, and the solid-cylindrical protected electrode 106B is connected with the wire 109B. Each of the wires 109A, 109B is connected with the AC source 109, respectively. It is not necessary to ground the wire and the housing. However, one or both of the wire and the housing may be grounded. In the embodiment shown in Fig. 1(b), both the housing 1 and the wire 9B are grounded.

In the protected/protected-electrodes-apparatus according to the present invention, a pair of the protected electrodes may be a combination of a pair of the solid-cylindrical protected electrodes containing the insulating coating layer carried in close contact as shown in Fig. 1(b), or a combination of the solid-cylindrical protected electrode containing the insulating coating layer carried in close contact as shown in Fig. 1(b) and the hollow-cylindrical protected electrode having a space in the inside as shown in Fig. 1(a).

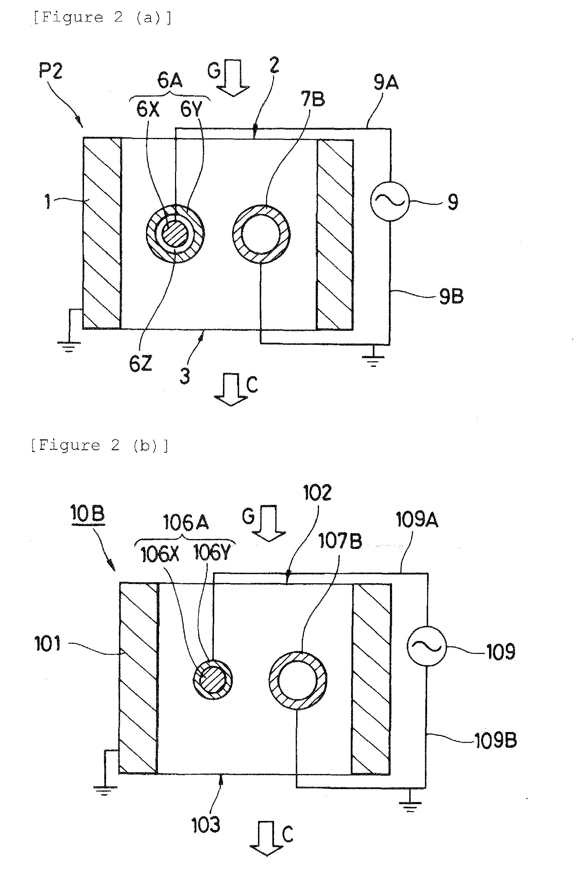

Then, Fig. 2(a) is a schematic sectional view illustrating an elemental structure of electrodes in a conventional protected/exposed-electrodes-apparatus P2, and Fig. 2(b) is a schematic sectional view illustrating an elemental structure of electrodes in a protected/exposed-electrodes-apparatus 10B which is an embodiment of the present invention.
The conventional apparatus P2 shown in Fig. 2(a) comprises the housing 1 having the inlet opening 2 for the gas G to be treated and the outlet opening 3 for the treated gas C. The hollow-cylindrical protected electrodes 6A and the solid-cylindrical exposed electrode 7 are provided inside the housing 1. The hollow-cylindrical protected electrode 6A contains the inner bar electrode 6X and the hollow-cylindrical sheath 6Y, as the hollow-cylindrical protected electrode 6A in the conventional apparatus P1 shown in Fig. 1 (a) . The hollow-cylindrical sheath 6Y is generally a glass tube, and surrounds the inner bar electrode 6X via the space 6Z. The hollow-cylindrical protected electrode 6A is connected with the electric cable 9A, and the hollow-cylindrical exposed electrode 7 is connected with the electric cable 9B. The electric cables 9A, 9B are connected with the AC source 9, respectively. It is not necessary to ground the wire and the housing. However, one or both of the wire and the housing may be grounded. In the embodiment shown in Fig. 2(a), both the housing 1 and the electric cable 9B are grounded. The above exposed electrode may be solid-cylindrical.

The hollow-cylindrical exposed electrode (or the solid-cylindrical exposed electrode) has a form corresponding to that prepared by removing a hollow-cylindrical sheath from a hollow-cylindrical protected electrode to directly expose an inner bar electrode. That is, the hollow-cylindrical exposed electrode (or the solid-cylindrical exposed electrode) can be made of any electrically conductive material, for example, aluminum or an alloy thereof, copper, carbonaceous material, iron or an alloy thereof, or tungsten. Further, the electrode surface of the hollow-cylindrical exposed electrode (or the solid-cylindrical exposed electrode) is brought into direct contact with the gas to be treated, and thus, it is preferable to use a metal, for example, stainless steel such as SUS, which has a corrosion resistance and an ease of maintenance, such as procedures for cleaning or replacement. Furthermore, a shape of the hollow-cylindrical exposed electrode (or the solid-cylindrical exposed electrode) is not particularly limited, and it may be a bar form (for example, a hollow-cylindrical form or a solid-cylindrical form, particularly a hollow-cylindrical form or a solid-cylindrical form), or a conductive wire per se or a twisted-wires-electrode prepared by twisting a conductive wire.

On the contrary, the present protected/exposed-electrodes-apparatus 10B shown in Fig. 2(b) comprises the housing 101 having the inlet opening 102 for the gas G to be treated and the outlet opening 103 for the treated gas C. The solid-cylindrical protected electrode 106A and the hollow-cylindrical exposed electrode 107B are provided in the housing 101. The solid-cylindrical protected electrode 106A contains the inner bar electrode 106X and the insulating coating layer 106Y. The insulating coating layer 106Y is carried on the inner bar electrode 106X in such a manner that the insulating coating layer 106Y is in close contact with the inner bar electrode 106X and covers the entire surface of the inner bar electrode 106X. Therefore, there is no space between the inner bar electrode 106X and the insulating coating layer 106Y. The gas to be treated is brought into contact with the insulating coating layer 106Y, but is not brought into contact with the inner bar electrode 106X. Instead of the hollow-cylindrical exposed electrode 107B, a solid-cylindrical exposed electrode as used in the conventional apparatus P2 as shown in Fig. 2(a) may be used. The hollow/solid-cylindrical exposed electrode has a form corresponding to that prepared by removing a hollow-cylindrical sheath from a hollow-cylindrical protected electrode to directly expose an inner bar electrode. The solid-cylindrical protected electrode 106A is connected with the wire 109A, and the hollow-cylindrical exposed electrode 107B is connected with the wire 109B. Each of the wires 109A, 109B is connected with the AC source 109, respectively. It is not necessary to ground the wire and the housing. However, one or both of the wire and the housing may be grounded. In the embodiment shown in Fig. 2(b), both the housing 1 and the wire 9B are grounded.

When the gas G to be treated is charged into the inlet opening 102 of the air-treating apparatus of the present invention as shown in Figs. 1(b) and 2(b), the gas G to be treated is passed between the solid-cylindrical protected electrode and the solid-cylindrical protected electrode [Fig. 1(b)], or the solid-cylindrical protected electrode and the hollow-cylindrical exposed electrode [Fig. 2(b)], and eventually discharged from the outlet opening 103. During this passage, an electrical voltage is applied between the pair of the solid-cylindrical protected electrodes 106A, 106B [Fig. 1(b)], or the solid-cylindrical protected electrode 106A and the hollow-cylindrical exposed electrode 107, and an electric discharge is caused to convert gas molecules into an excited state and generate radicals. Malodorous substances in the gas to be treated are oxidized and decomposed by the above radicals, or ozone is generated by the above radicals and the gas to be treated is oxidized. Further, the gas to be treated is discharged from the outlet opening and conveyed to a catalyst chamber (not shown) filled with an oxidation catalyst, together with the generated radicals and ozone so that the reaction of the gas to be treated and the radicals and ozone can proceed to continue the treatment of the gas.

In Figs. 1(b) and 2(b), the arrangement of the electrodes in the air-treating apparatus of the present invention is schematically illustrated for the sake of convenience of explanation, and only two electrodes, that is, a pair of the electrodes, are shown. However, in an actual embodiment of the air-treating apparatus of the present invention, the first electrodes-group composed of plural electrodes and the second electrodes-group composed of plural electrodes are provided, and the gas can be treated by applying an electric voltage therebetween. In the present invention, at least one of the protected electrodes belonging to the first electrodes-group and/or the protected electrodes belonging to the second electrodes-group may be a protected electrode carrying the insulating coating layer. It is preferable that all of the protected electrodes are the protected electrode carrying the insulating coating layer.

The insulating coating layer carried on the surface of the core electrode is, for example, a porcelain enameled coating layer, a ceramic coating layer, a glass coating layer, or a resin coating layer. The porcelain enameled coating layer can be formed by baking a vitreous glaze on the surface of the metallic core electrode by a known method. The metallic material from which the porcelain enameled coating layer can be formed is, for example, aluminum, iron, steel, or copper.

The ceramic coating layer can be formed by spraying a molten metallic compound on the surface of the core electrode (for example, a metallic or carbonaceous core electrode) and cooling it, or dipping the core electrode (for example, a metallic or carbonaceous core electrode) in a molten metallic compound and cooling, by a known method. The material used for the ceramic coating layer is not particularly limited so long as it is a metallic compound having an insulating property, and may be, for example, alumina, zirconia, titania, magnesia, and/or silicon carbide.

The glass coating layer can be formed by spraying a molten glass on the surface of the core electrode (for example, a metallic or carbonaceous core electrode) and cooling, or dipping the core electrode (for example, a metallic or carbonaceous core electrode) in a molten glass and cooling. The material used for the glass coating layer is not particularly limited, and may be, for example, borosilicate glass.

The resin coating layer also can be formed on the surface of the core electrode (for example, a metallic or carbonaceous core electrode) by a known method, for example, by coating, spraying, extruding, dipping, electrostatic depositing, or fluidized-bed coating from a synthetic resin on the surface of the core electrode.
The material used for the resin coating layer is not particularly limited so long as it is a synthetic resin having an insulating property, and may be, for example, a thermosetting resin (for example, polyurethane resin, phenol resin, diallyl phthalate resin, epoxy resin, or silicone resin), or a thermoplastic resin (for example, polystyrene, polyethylene, polypropylene, polysulfone resin, polyphenyl sulfone resin, fluororesin, or saturated polyester), which can be used singly or in a combination of two or more.

The thickness of the insulating coating layer carried on the surface of the core electrode is not particularly limited, so long as a discharge can be caused between the electrodes, gas molecules can be excited, and radicals can be generated. The thickness is, for example 0.1 to 5 mm, preferably 0.2 to 1 mm. In the range of the practical electrical voltage applied for the purpose of the excitation of gas, when the thickness of the insulating coating layer is less than 0.1 mm, a dielectric breakdown of the insulating coating layer is easily caused, whereas when the thickness is more than 5 mm, it is difficult to cause a silent electric discharge in the gas-exciting apparatus.

As mentioned, the conventional gas-exciting apparatus as shown in Figs. 25 and 26 is generally assembled by positioning many hollow-cylindrical electrodes in the housing 1. The procedure for fixing each respective hollow-cylindrical electrode in the housing one by one is troublesome and raises the production cost. As shown in Fig. 27, hollow-cylindrical electrodes are placed in the housing in the form of an electrodes-block containing some hollow-cylindrical electrodes. However, the procedures per se of assembling the electrodes-block comprises fixing each respective hollow-cylindrical electrode on side plates or the like one by one, and thus, any lowering of the cost is limited. These disadvantages remain even in the gas-exciting apparatus according to the present invention using the protected electrode formed from the inner bar electrode and the insulating coating layer.

When a hollow-cylindrical electrode in the gas-exciting apparatus as shown in Figs. 25 and 26 fails, for example, is damaged, and the gas-exciting apparatus is continuously operated without replacing the failed electrode, normal electrodes surrounding the failed electrode will be damaged. Thus, a replacement of the failed electrode is important for maintenance of a gas-exciting apparatus. However, such a procedure of replacing one or a small number of failed electrodes among many hollow-cylindrical electrodes is very troublesome, and it is one of the causes of increase of maintenance costs. This disadvantage cannot be essentially remedied by the gas-exciting apparatus according to the present invention using the protected electrode formed from the inner bar electrode and the insulating coating layer.

Further, when contaminated air is treated by the gas-exciting apparatus as shown in Figs. 25 and 26, the surface of the hollow-cylindrical electrode is fouled. When the gas-exciting apparatus with fouled electrodes is continuously operated, a gas exciting capacity is greatly lowered, and thus, a periodical cleaning is necessary. However, a cleaning of the gas-exciting apparatus containing many hollow-cylindrical electrodes placed therein is also very troublesome, and is one of the causes of an increase of maintenance cost. This disadvantage cannot be essentially remedied by the gas-exciting apparatus according to the present invention using the protected electrode as above.

In the gas-exciting apparatus containing the first electrodes-group composed of plural hollow- or solid-protected electrodes and the second electrodes-group composed of plural hollow- or solid-protected electrodes, the various disadvantages as above can be remedied by the replacement of plural hollow- or solid-protected electrodes belonging to the first electrodes-group or plural hollow- or solid-protected electrodes belonging to the second electrodes-group with a single plate electrode. Accordingly, the present invention can be effectively applied to an embodiment wherein plural hollow- or solid-protected electrodes belonging to the first electrodes-group and/or the second electrodes-group are replaced with a single plate electrode in the gas-exciting apparatus containing the first electrodes-group and the second electrodes-group composed of plural hollow- or solid-protected electrodes.

Various embodiments of the gas-exciting apparatus according to the present invention containing the plate electrode will be described hereinafter.

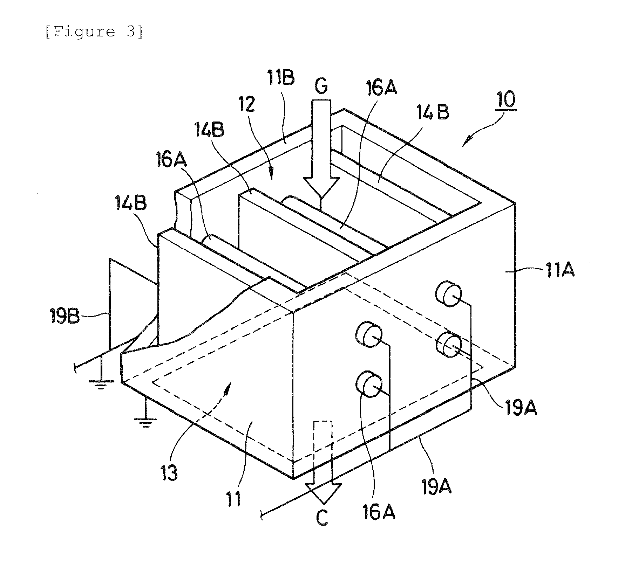

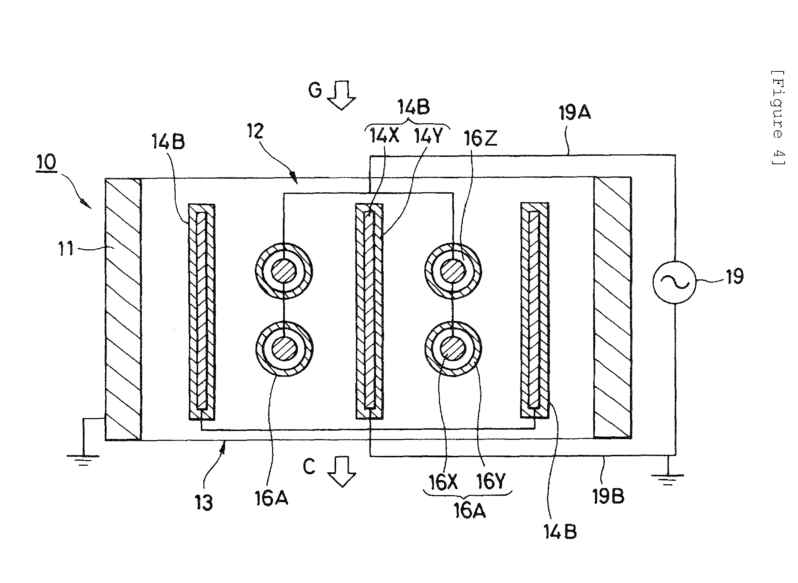

Fig. 3 is a schematic perspective view of the present apparatus 10 having a structure wherein plural hollow- or solid-protected electrodes are replaced with a single plate electrode, and a part of the side wall of the housing 11 is cut away. Fig. 4 is a schematic sectional view thereof. As apparent when comparing Figs. 3 and 4 (the present invention) and Figs. 25 and 26 (prior art), the present apparatus 10 has a structure such that each group of the plural hollow-cylindrical protected electrodes belonging to each line of the first electrodes-groups 6L in the conventional apparatus P (Figs. 25 and 26) is replaced with a single protected plate electrode 14B. Namely, the first protected plate electrode 14B is placed in parallel to the direction of a stream of the gas G to be treated, that is, in parallel to the inside wall of the housing 11, at a position facing the inside wall of the housing 11, that is, at one end of the electrodes-groups. Then, the first line of the second electrodes-group composed of the hollow-cylindrical protected electrodes 16A in a line as a group is placed in parallel to the first protected plate electrode 14B. Then, in a similar manner, the second and subsequent protected plate electrodes 14B and the second and subsequent lines of the hollow-cylindrical protected electrodes-groups are placed in parallel alternately one after another. The protected plate electrode 14B is placed at a position facing another inside wall of the housing 11, that is, at the other end of the electrodes-groups.

The protected plate electrode 14B is composed of the inner plate electrode 14X and the insulating coating layer 14Y. The insulating coating layer 14Y is carried on the surface of the inner plate electrode 14X in such a manner that the insulating coating layer 14Y is in close contact with the inner plate electrode 14X and covers the entire surface of the inner plate electrode 14X. Therefore, there is no space between the inner plate electrode 14X and the insulating coating layer 14Y. The gas to be treated is brought into contact with the insulating coating layer 14Y, but is not brought into contact with the inner plate electrode 14X.

Each hollow-cylindrical protected electrode 16A is connected with the wire 19A, and the protected plate electrode 14B is connected with the wire 19B. Each of the wires 19A, 19B is connected with the AC source 19, respectively. A high voltage is applied between the hollow-cylindrical protected electrode 16A and the protected plate electrode 14B. It is not necessary to ground the wire and the housing. However, one or both of the wire and the housing may be grounded. In the embodiment shown in Figs. 3 and 4, both the housing 11 and the wire 19 are grounded.

As shown in Fig. 3, the protected plate electrode 14B may be a single protected plate electrode continuously extending from around the end of the inlet opening 12 to around the end of the outlet opening 13 in the housing 11 along the direction of the streaming of the gas G to be treated. Alternatively, it may have a structure wherein the continuous single protected plate electrode as above is divided into plural plates along the direction of the streaming of the gas G to be treated, that is, two or more protected plate electrodes may be placed on a line along the direction of the streaming of the gas G to be treated. In this case, each protected plate electrode has a function corresponding to plural conventional hollow-cylindrical protected electrodes.

In the conventional apparatus P as shown in Figs. 25 and 26, each line of the electrodes-groups 6L is composed of many hollow-cylindrical protected electrodes 6B, and thus such a structure is one of the causes of an increase in the costs for assembly and maintenance. On the contrary, the present apparatus 10 as shown in Figs. 3 and 4 has a structure wherein a single protected plate electrode 14B is contained instead of many hollow-cylindrical protected electrodes, and thus the assembly and maintenance costs are greatly reduced.

The hollow-cylindrical protected electrode 16A may be the conventional protected electrode, which is composed of the glass sheath 16Y and the metal bar electrode 16X and contains the inside void 16z, as shown in Figs. 3 and 4. Alternatively, instead of all or a part of the hollow-cylindrical protected electrodes 16A as above, the solid-cylindrical protected electrode as shown in Figs. 1(b) and 2(b), that is, the solid-cylindrical protected electrode composed of the inner bar electrode 6X and the insulating coating layer 6Y which surrounds the inner bar electrode 6X in close contact therewith, may be used.

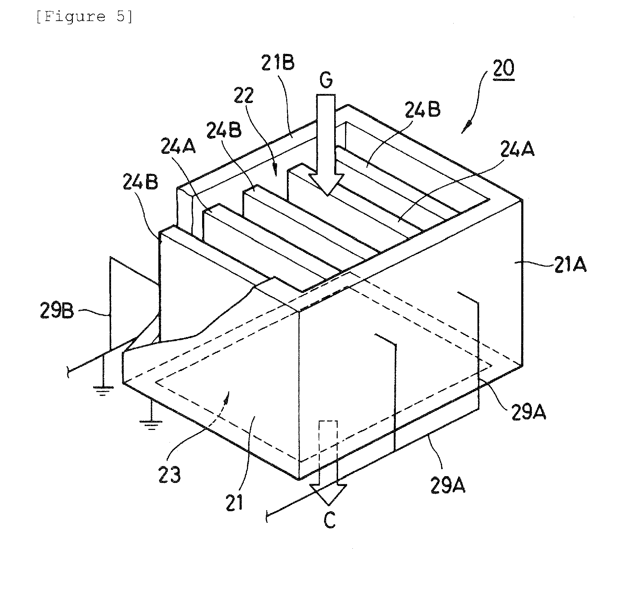

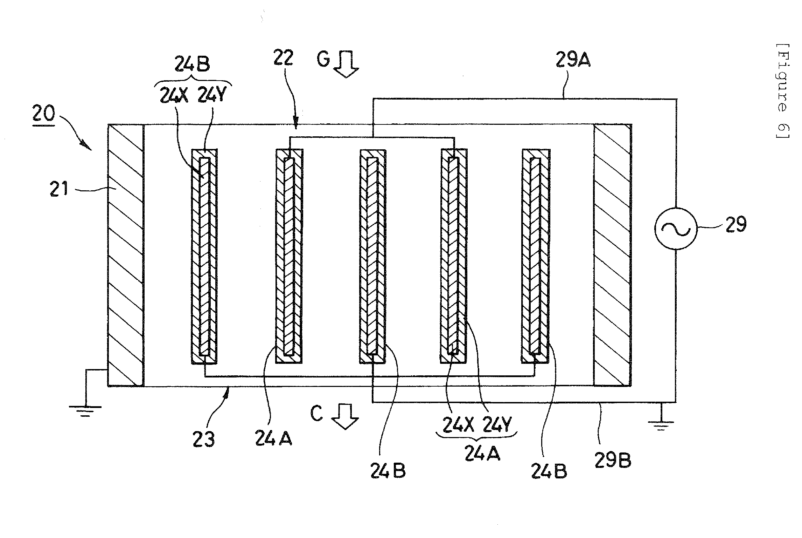

Fig. 5 is a schematic perspective view of the present apparatus 20 having a structure wherein all of the hollow-or solid-protected electrodes are replaced with the plate electrodes, and a part of the side wall of the housing 21 is cut away. Fig. 6 is a schematic sectional view thereof. As apparent when comparing Figs. 5 and 6 (the present invention) and Figs. 25 and 26 (prior art), the present apparatus 20 has a structure wherein each group of the plural hollow-cylindrical protected electrodes belonging to each line of the first electrodes-groups 6L in the conventional apparatus P (Figs. 25 and 26) is replaced with a single protected plate electrode 24B, and at the same time, each group of the plural hollow-cylindrical protected electrodes belonging to each line of the second electrodes-groups 6H in the conventional apparatus P (Figs. 25 and 26) is replaced with a single protected plate electrode 24A. In this embodiment, all of the electrodes-groups are the protected plate electrodes, and thus the assembly and maintenance costs are greatly reduced.

Each of the protected plate electrodes 24A, 24B is composed of the inner plate electrode 24X and the insulating coating layer 24Y. The insulating coating layer 24Y is carried on the surface of the inner plate electrode 24X in such a manner that the insulating coating layer 24Y is in close contact with the inner plate electrode 24X and covers the entire surface of the inner plate electrode 24X. Therefore, there is no space between the inner plate electrode 24X and the insulating coating layer 24Y. The gas to be treated is brought into contact with the insulating coating layer 24Y, but is not brought into contact with the inner plate electrode 24X. As shown in Fig. 5, the protected plate electrodes 24A, 24B may be a single protected plate electrode continuously extending from around the end of the inlet opening 22 to around the end of the outlet opening 23 in the housing 21 along the direction the streaming of the gas G to be treated. Alternatively, two or more divided protected plate electrodes may be used.

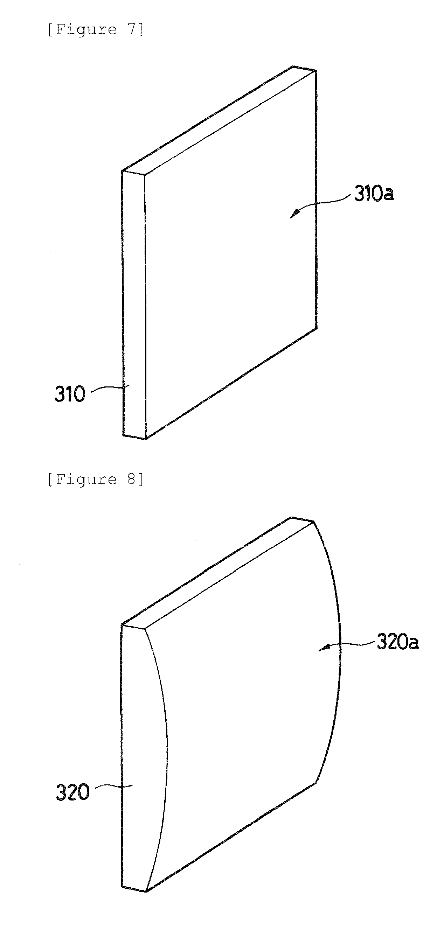

The shape of the inner plate electrode is not particularly limited, so long as it is a plate which allows a stable discharge. Specifically, for example, a smooth plate electrode having a smooth surface, a concave-convex plate electrode having a concave-convex structure on the surface, or a through-holes-plate electrode having through-holes may be used. The smooth plate electrode may be, for example, the plate electrode 310 having a flat surface 310a as shown in Fig. 7, or the plate electrode 320 having a rounded surface 320a as shown in Fig. 8. The smooth rounded surface means not only a convex smooth rounded surface as shown in Fig. 8, but also a concave smooth rounded surface.

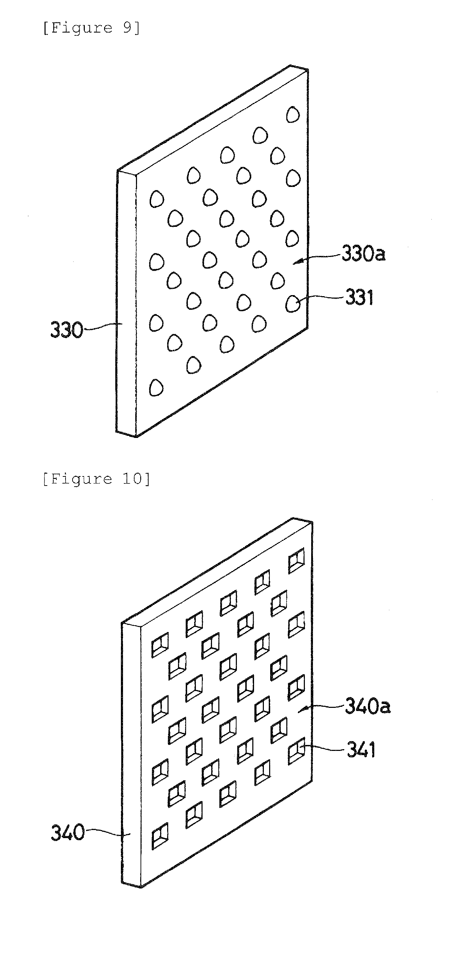

The concave-convex plate electrode having a concave-convex structure on the surface may be, for example, the concave-convex plate electrode 330 having many projected cones 331 dispersed as a scatter on the flat surface 330a as shown in Fig. 9. The shape of the projections is not limited to a core, but may be a hemisphere or a regular hexahetron. Further, it may be the concave-convex plate electrode 340 having many regular hexahedron depressed portions 341 dispersed as a scatter on the flat surface 340a as shown in Fig. 10. The shape of the depressed portion is not limited to the regular hexahedron, but may be a cone or a hemisphere.

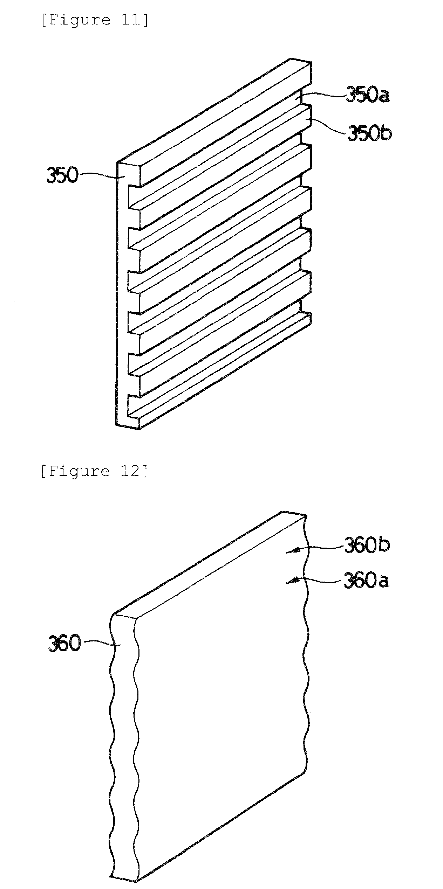

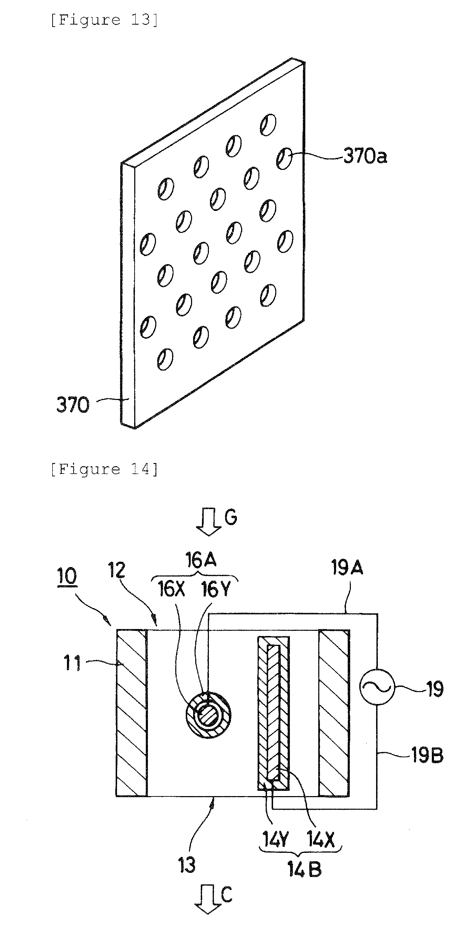

Further, the concave-convex plate electrode may be, for example, the concave-convex plate electrode 350 containing many zonal grooves 350a and zonal projections 350b which are arranged in parallel to each other, as shown in Fig. 11. The zonal grooves and the zonal projections may be not only linearly arranged, but also arranged in parallel in many curved lines. The concave-convex plate electrode may be, for example, the concave-convex plate electrode 360 having corrugated surfaces formed by the zonal grooves 360a having a generally hemicyclic section and the zonal projections 360b having a generally hemicyclic section, as shown in Fig. 12.

The inner plate electrode may have a smooth plate surface on one side, and a concave-convex plate surface on the other side. Further, the inner plate electrode may have smooth plate surfaces or concave-convex plate surfaces on both sides. In this case, the shapes of the smooth plate surfaces or the concave-convex plate surfaces may be identical to or different from each other.

The through-holes-plate electrode may be, for example, the perforated plate electrode 370 formed by punching out many holes 370a in a plate of an electrically conductive material, as shown in Fig. 13. As mentioned below, the through-holes-plate electrode may be, for example, a reticular electrode formed from fibers of a thin electrically conductive material.

The insulating coating layer (for example, a porcelain enameled coating layer, a ceramic coating layer, a glass coating layer, or a resin coating layer) carried on various inner plate electrodes as above may be formed on the surfaces of various inner plate electrodes by a known method, as the insulating coating layer carried on the surfaces of the solid-cylindrical core electrodes as above.

The insulating coating layer (for example, a ceramic coating layer, a glass coating layer, such as a glass plate, or a resin coating layer, such as a resin film) carried on the surface of the inner plate electrode may be formed by a known method similar to that for forming the insulating coating layer carried on the surface of the above solid-cylindrical core electrode, or alternatively, by forming a ceramic coat plate, a glass coat plate, or a resin coat plate in advance, and then adhering the plate to the surface of the inner plate electrode with an adhesive agent, whereby the insulating coating layer is carried thereon.

A preferable combination of the paired electrodes connected with the AC source is a combination of two protected plate electrodes (closely-contacting protected plate electrodes), each of which is composed of the inner plate electrode 24X and the insulating coating layer 24Y carried on the surface thereof in such a manner that the insulating coating layer 24Y is in close contact with the inner plate electrode 24X and covers the entire surface of the inner plate electrode 24X and thus no space exists therebetween, as shown in Figs. 5 and 6. However, the paired electrodes may be a combination of the closely-contacting protected plate electrode as one electrode, and the protected plate electrode (space-containing protected plate electrode) comprising a plate electrode stored in an insulating sheath (particularly, a housing of glass plates or synthetic resin plates) and containing a space between the outer insulating sheath and the inner plate electrode, as the other electrode.

Where the paired electrodes are the combination of the protected plate electrode as one electrode, and the solid-cylindrical protected electrode, that is, the solid-cylindrical protected electrode composed of the inner bar electrode 6X and the insulating coating layer 6Y surrounding the inner bar electrode 6X in a closely contacting manner as the other electrode, the closely-contacting protected plate electrode or the space-containing protected plate electrode may be used as the protected plate electrode as above.

The shape of the inner plate electrode in the space-containing protected plate electrode is not particularly limited, so long as it is a plate which allows a stable discharge. The inner plate electrode may be, for example, a smooth plate electrode having a smooth surface, a concave-convex plate electrode having a concave-convex structure on the surface, or a through-holes-plate electrode containing through-holes, as shown in Fig. 7 to Fig. 13. However, in the case of the concave-convex plate electrode having a concave-convex structure on the surface, an inside discharge may be caused between the outside insulating sheath and the inner plate electrode to shorten a lifetime of the inner electrode or to lower the efficiency of a gas-excitation. Thus, it is preferable to use the smooth plate electrode.

The thickness of the insulating coating layer carried on the surface of the inner plate electrode is not limited so long as a discharge is generated between the electrodes to excite gas molecules and generate radicals, and is for example, 0.1 to 5mm, preferably, 0.2 to 1mm. In the range of the practical electrical voltage applied for the purpose of gas excitation, when the thickness of the insulating coating layer is less than 0.1 mm, a dielectric breakdown of the insulating coating layer is easily caused, whereas when the thickness is more than 5 mm, it is difficult to cause a silent electric discharge in the gas-exciting apparatus.

As explained with the reference to Fig. 3 to Fig. 6, the gas-exciting apparatus according to the present invention containing the plate electrode corresponds to an embodiment wherein plural hollow- or solid-protected electrodes belonging to the first electrodes-group and/or the second electrodes-group are replaced with a single plate electrode, and the combination of the first electrodes-group and the second electrodes-group is,
(1) a combination of a protected electrode and a protected electrode, or
(2) a combination of a protected electrode and an exposed electrode.
   Therefore, the gas-exciting apparatus according to the present invention involves an embodiment wherein the plate electrode is the protected electrode, and an embodiment
wherein the plate electrode is the exposed electrode. Various combinations with the above respect will be described hereinafter, referring to schematic sectional views illustrating an elemental structure of the electrodes.

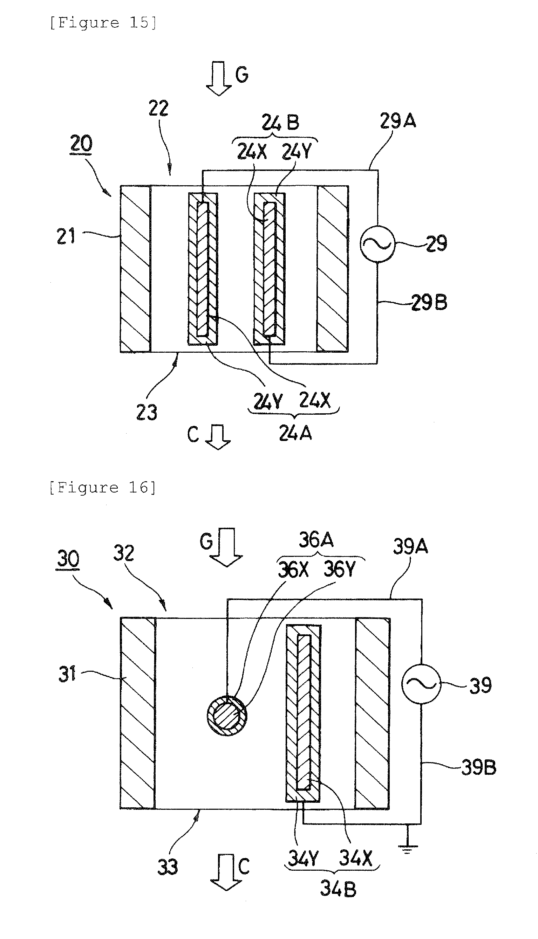

Fig. 14 is a schematic sectional view illustrating an elemental structure of electrodes in the embodiment shown in Figs. 3 and 4. The protected/protected-electrodes-apparatus 10 of the present invention as shown in Fig. 14 comprises the housing 11 containing the inlet opening 12 for the gas G to be treated and the outlet opening 13 for the treated gas C. The housing 11 contains therein the hollow-cylindrical protected electrode 16A and the protected plate electrode 14B. The protected plate electrode 14B as one of the protected electrodes is composed of the inner plate electrode 1.4X and the insulating coating layer 14Y. The insulating coating layer 14Y is carried on the surface of the inner plate electrode 14X in such a manner that the insulating coating layer 14Y is in close contact with the inner plate electrode 14X and covers the entire surface of the inner plate electrode 14X. Therefore, there is no space between the inner plate electrode 14X and the insulating coating layer 14Y. The hollow-cylindrical protected electrode 16A as the other protected electrode contains a space 16Z between the inner bar electrode 16X and the hollow-cylindrical insulating coating layer 16Y. The hollow-cylindrical protected electrode 16A is connected with the wire 19A and the protected plate electrode 14B is connected with the wire 19B. The wires 19A, 19B are connected with the AC source 19. One or both of the wire and the housing may be grounded or not grounded.

When the hollow-cylindrical protected electrode 16A and the protected plate electrode 14B are placed at the positions facing the housing 11 as in the embodiment shown in Fig. 14, a discharge may be caused between the housing 11 and one or both of the electrodes 16A, 14B in addition to the desired discharge between the electrodes 16A, 14B. If the housing 11 is exposed to the discharge, it may be damaged depending on the material thereof. The housing 11 essentially has functions to fix the electrodes or hold the other electrodes-blocks Q (Fig. 27) in the gas-exciting apparatus, and the damage as above is not desirable. Therefore, it is also desirable to prevent a discharge between the housing 11 and the electrodes 16A, 14B, from a safety point of view.

The purpose of grounding the housing 11 and the electrodes-groups (outer electrodes) placed at the positions facing the inside wall of the housing is to prevent the discharge between the housing 11 and the hollow-cylindrical protected electrodes 16A or the protected plate electrodes 14B. Alternative methods for preventing the above discharge are, for example, a method for spacing the outer electrodes from the inside wall of the housing so that a discharge is not caused, or a method for controlling the voltage applied to the electrodes so that a discharge is not caused between the outer electrodes and the inside wall of the housing.

Fig. 15 is a schematic sectional view illustrating an elemental structure of electrodes in the embodiment shown in Figs. 5 and 6. The protected/protected-electrodes-apparatus 20 of the present invention as shown in Fig. 15 comprises the housing 21 containing the inlet opening 22 for the gas G to be treated and the outlet opening 23 for the treated gas C. The housing 21 contains therein the protected plate electrodes 24A, 24B. The protected plate electrodes 24A, 24B are composed of the inner plate electrode 24X and the insulating coating layer 24Y. The insulating coating layer 24Y is carried on the surface of the inner plate electrode 24X in such a manner that the insulating coating layer 24Y is in close contact with the inner plate electrode 24X and covers the entire surface of the inner plate electrode 24X. There is no space between the inner plate electrode 24X and the insulating coating layer 24Y. The protected plate electrode 24A is connected with the wire 29A and the protected plate electrode 24B is connected with the wire 29B. The wires 29A, 29B are connected with the AC source 29. A high voltage is applied between the protected plate electrodes 24A, 24B. One or both of the wire and the housing may be grounded or not grounded. In the present apparatus 20 as shown in Fig. 15, a discharge between the housing 21 and the protected plate electrodes 24A, 24B can be prevented by the same methods as above.

In the embodiment shown in Fig. 15, one of the protected plate electrode 24A and the protected plate electrode 24B may be the closely-contacting protected plate electrode, and the other may be the space-containing protected plate electrode. When the protected plate electrode 24A or the protected plate electrode 24B is composed of plural protected plate electrodes, a part of the electrodes may be the space-containing protected plate electrode.

Fig. 16 is a schematic sectional view illustrating an elemental structure of electrodes in the still another embodiment of the protected/protected-electrodes-apparatus of the present invention. The present protected/protected -electrodes-apparatus 30 comprises the housing 31 containing the inlet opening 32 for the gas G to be treated and the outlet opening 33 for the treated gas C. The housing 31 contains therein the solid-cylindrical protected electrode 36A and the protected plate electrode 34B. The solid-cylindrical protected electrode 36A contains the inner bar electrode 36X and the insulating coating layer 36Y. The insulating coating layer 36Y is carried on the surface of the inner bar electrode 36X in such a manner that the insulating coating layer 36Y is in close contact with the inner bar electrode 36X and covers the entire surface of the inner bar electrode 36X. Therefore, there is no space between the inner bar electrode 36X and the insulating coating layer 36Y.

The protected plate electrode 34B is composed of the inner plate electrode 34X and the insulating coating layer 34Y. The insulating coating layer 34Y is carried on the surface of the inner plate electrode 34X in such a manner that the insulating coating layer 34Y is in close contact with the inner plate electrode 34X and covers the entire surface of the inner plate electrode 34X. There is no space between the inner plate electrode 34X and the insulating coating layer 34Y. The solid-cylindrical protected electrode 36A is connected with the wire 39A, the protected plate electrode 34B is connected with the wire 39B, and the wires 39A, 39B are connected with the AC source 39. A high voltage is applied between the solid-cylindrical protected electrode 36A and the protected plate electrode 34B. One or both of the wire and the housing may be grounded or not grounded. In the present apparatus 30 as shown in Fig. 16, a discharge between the housing 31 and the solid-cylindrical protected electrode 36A or the protected plate electrode 34B can be prevented by the same methods as above.

In the embodiment shown in Fig. 16, the protected plate electrode 34B may be the closely-contacting protected plate electrode or the space-containing protected plate electrode. When the protected plate electrode 34B is composed of plural protected plate electrodes, a part of the electrodes may be the space-containing protected plate electrode.

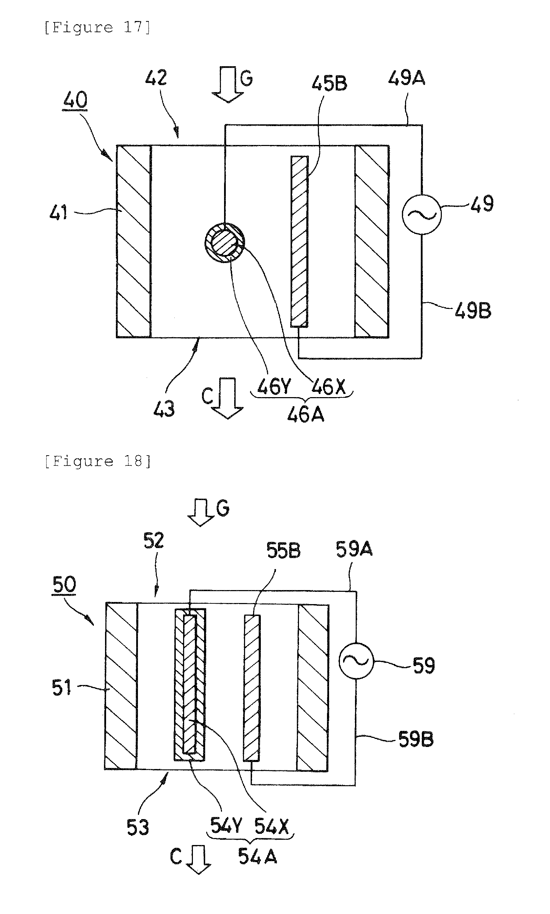

Fig. 17 is a schematic sectional view illustrating an elemental structure of electrodes in the embodiment of the protected/exposed-electrodes-apparatus of the present invention. The present protected/exposed-electrodes-apparatus 40 shown in Fig. 17 comprises the housing 41 containing the inlet opening 42 for the gas G to be treated and the outlet opening 43 for the treated gas C. The housing 41 contains therein the solid-cylindrical protected electrode 46A and the exposed plate electrode 45B. The solid-cylindrical protected electrode 46A contains the inner bar electrode 46X and the insulating coating layer 46Y. The insulating coating layer 46Y is carried on the surface of the inner bar electrode 46X in such a manner that the insulating coating layer 46Y is in close contact with the inner bar electrode 46X and covers the entire surface of the inner bar electrode 46X. Therefore, there is no space between the inner bar electrode 46X and the insulating coating layer 46Y.

On the other hand, the exposed plate electrode 45B has a form corresponding to that prepared by removing an insulating coating layer from a protected plate electrode to directly expose an inner plate electrode, and is not particularly limited so long as it allows a stable discharge. Specifically, it may be a smooth plate electrode having a smooth surface, a concave-convex plate electrode having a concave-convex structure on the surface, or a through-holes plate electrode containing through-holes.
The exposed plate electrode may be made of any electrically conductive materials, for example, aluminum or an alloy thereof, copper, carbonaceous material, iron or an alloy thereof, or tungsten. Further, the exposed electrode is brought into direct contact with the gas to be treated, and thus, it is preferable to use a metal, for example, stainless steel such as SUS, which has a corrosion resistance and an ease of maintenance for cleaning or replacement procedures.

The solid-cylindrical protected electrode 46A is connected with the wire 49A, the exposed plate electrode 45B is connected with the wire 49B and the wires 49A, 49B are connected with the AC source 49. A high voltage is applied between the solid-cylindrical protected electrode 46A and the exposed plate electrode 45B. The wire and the housing may be grounded or not grounded.

In the present apparatus 40 as shown in Fig. 17, a discharge between the housing 41 and the solid-cylindrical protected electrode 46A or the exposed plate electrode 45B can be prevented by the same methods as above. Both ends of the exposed plate electrode 45B are generally held on the wall of the housing 41, which is the same as the wall holding both ends of the solid-cylindrical protected electrode 46A. If the distance between the exposed plate electrode 45B and the solid-cylindrical protected electrode 46A is short, a surface discharge may be caused on the holding wall of the housing 41. As shown in Fig. 20, the surface discharge as above may be prevented, for example, by fixing the exposed plate electrode 5 on the housing (not shown) via the sheaths 60Z of an insulating material arranged at both ends of the exposed plate electrode 5 so as to substantially extend the distance capable of allowing a surface discharge between the exposed end 5A of the exposed plate electrode 5 and the adjacent hollow-cylindrical protected electrode.

Fig. 18 is a schematic sectional view illustrating an elemental structure of electrodes in another embodiment of the protected/exposed-electrodes-apparatus of the present invention. The present protected/exposed -electrodes-apparatus 50 shown in Fig. 18 comprises the housing 51 containing the inlet opening 52 for the gas G to be treated and the outlet opening 53 for the treated gas C. The housing 51 contains therein the protected plate electrode 54A and the exposed plate electrode 55B. The protected plate electrode 54A contains the inner plate electrode 54X and the insulating coating layer 54Y. The insulating coating layer 54Y is carried on the surface of the inner plate electrode 54X in such a manner that the insulating coating layer 54Y is in close contact with the inner plate electrode 54X and covers the entire surface of the inner plate electrode 54X. Therefore, there is no space between the inner plate electrode 54X and the insulating coating layer 54Y. The exposed plate electrode 55B is an exposed plate electrode, which is the same as the exposed plate electrode 45B shown in Fig. 17. The protected plate electrode 54A is connected with the wire 59A, the exposed plate electrode 55B is connected with the wire 59B and the wires 59A, 59B are connected with the AC source 59. A high voltage is applied between the protected plate electrode 54A and the exposed plate electrode 55B. The wire and the housing may be grounded or not grounded.

In the present apparatus 50 as shown in Fig. 18, a discharge between the housing 51 and the protected plate electrode 54A or the exposed plate electrode 55B can be prevented by the same methods as above, and a surface discharge on the holding wall surface of the housing 51 can also be prevented by the same methods as above.

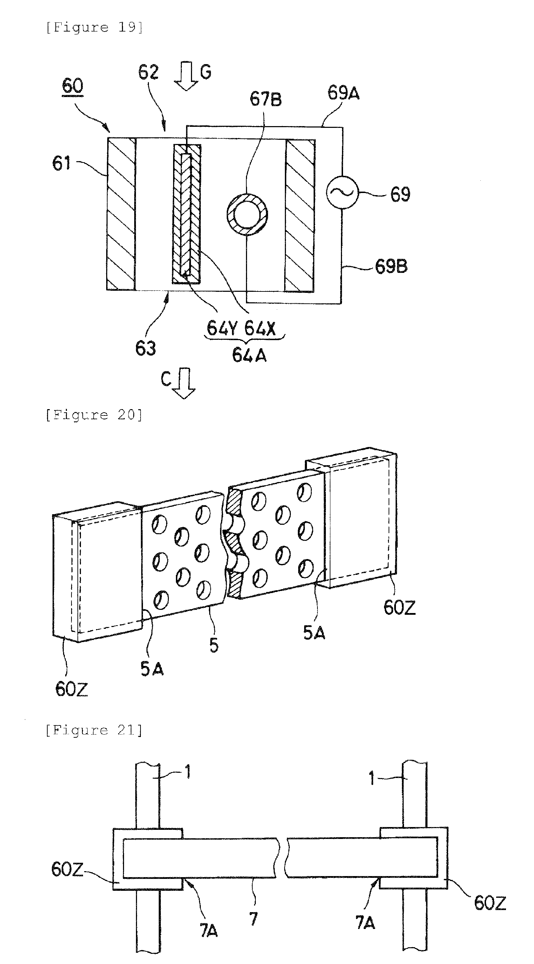

Fig. 19 is a schematic sectional view illustrating an elemental structure of electrodes in still another embodiment of the protected/exposed-electrodes-apparatus of the present invention. The protected/exposed-electrodes-apparatus 60 shown in Fig. 19 comprises the housing 61 containing the inlet opening 62 for the gas G to be treated and the outlet opening 63 for the treated gas C. The housing 61 contains therein the protected plate electrode 64A and the hollow/solid-cylindrical exposed electrode 67B. The protected plate electrode 64A contains the inner plate electrode 64X and the insulating coating layer 64Y. The insulating coating layer 64Y is carried on the surface of the inner plate electrode 64X in such a manner that the insulating coating layer 64Y is in close contact with the inner plate electrode 64X and covers the entire surface of the inner plate electrode 64X. Therefore, there is no space between the inner plate electrode 64X and the insulating coating layer 64Y.

The hollow/solid-cylindrical exposed electrode has a form corresponding to that prepared by removing the hollow-cylindrical sheath from the hollow-cylindrical protected electrode to directly expose the inner bar electrode. The hollow/solid-cylindrical exposed electrode can made of any electrically conductive material, for example, aluminum or an alloy thereof, copper, carbonaceous material, iron or an alloy thereof, or tungsten. The hollow/solid-cylindrical exposed electrode is brought into direct contact with the gas to be treated, and thus it is preferable to use a metal, for example, stainless steel such as SUS, which has a corrosion resistance and an ease of maintenance for cleaning or replacement procedures. Furthermore, a shape of the hollow/solid-cylindrical exposed electrode is not particularly limited, and it may be a bar form (for example, a hollow-cylindrical form or a solid-cylindrical form, particularly a hollow-cylindrical form or a solid-cylindrical form), or a conductive wire per se or a twisted-wires-electrode prepared by twisting a conductive wire.

In the present protected/exposed-electrodes-apparatus 60 shown in Fig. 19, the protected plate electrode 64A is connected with the wire 69A, the hollow/solid-cylindrical exposed electrode 67B is connected with the wire 69B, and the wires 69A, 69B are connected with the AC source 69. A high voltage is applied between the protected plate electrode 64A and the hollow/solid-cylindrical exposed electrode 67B. The wire and the housing may be grounded or not grounded. In the present apparatus 60 as shown in Fig. 19, a discharge between the housing 61 and the protected plate electrode 64A or the hollow/solid-cylindrical exposed electrode 67B can be prevented by the same methods as above, and a surface discharge on the holding wall surface of the housing 61 can also be prevented by the same methods as above. Specifically, for example, as shown in Fig. 21, the surface discharge as above may be prevented, for example, by fixing the hollow/solid-cylindrical exposed electrode 7 on the housing 1 via the sheaths 60Z of an insulating material arranged at both ends of the hollow/solid-cylindrical exposed electrode 7 so as to substantially extend the distance capable of allowing a surface discharge between the exposed end 7A of the exposed plate electrode 7 and the adjacent hollow-cylindrical protected electrode.

As the conventional apparatus P, the gas-exciting apparatus according to the present invention contains the inlet opening for the gas G to be treated at the position corresponding to an upper portion of the generally rectangular parallelepiped housing, and the outlet opening for the treated gas C at the position corresponding to a bottom portion of the housing. In the housing wherein a high-pressure discharge treatment (exciting treatment) is carried out, plural various electrodes are positioned separately from each other at a distance capable of discharging. The electrodes are arranged in a direction such that the stream of the gas to be treated is not obstructed. Both ends of the electrodes are held on the supporting walls of the housing, respectively. It is preferable that the electrodes-groups are positioned in the housing in such a manner that a discharge is substantially evenly caused in the housing, and the gas to be treated is substantially evenly treated when passing through between the electrodes.

When the gas G to be treated is introduced into the inlet opening of the air-treating apparatus of the present invention, the gas G to be treated is passed between hollow/solid-cylindrical protected electrodes and the protected plate electrodes, between the protected plate electrodes and the protected plate electrodes, between the hollow/solid-cylindrical protected electrodes and the exposed plate electrode, between the protected plate electrodes and the exposed plate electrodes, or between the protected plate electrodes and the hollow/solid-cylindrical exposed electrodes, and eventually discharged from the outlet opening. During the passage, a voltage is applied between the first electrodes-groups and the second electrodes-groups to cause a discharge therebetween, whereby gas molecules are excited and radicals are generated. The radicals oxidize and decompose malodorous substances in the gas to be treated and generate ozone so that the gas to be treated is oxidized. If the gas to be treated is discharged from the outlet opening together with the generated radicals and ozone and conveyed to a catalyst chamber filled with oxidizing catalysts, a reaction of the radicals and ozone with the gas to be treated can be further carried out to continue the treatment of the gas.

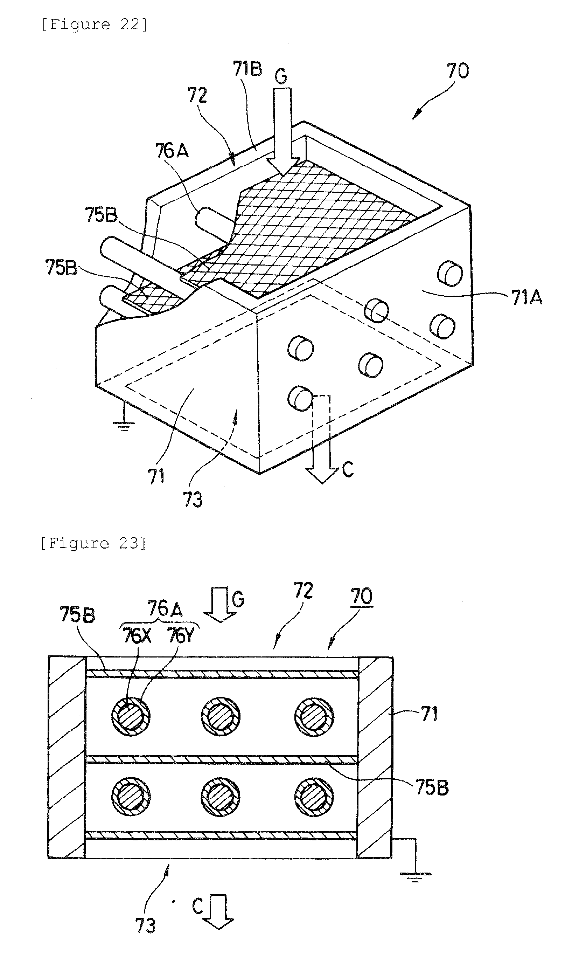

When the through-holes plate electrode is used as the exposed plate electrode in the present protected/exposed-electrodes-apparatus, the first electrodes-groups and the second electrodes-groups can be arranged perpendicular to the direction of the streaming of the gas G to be treated, respectively, for example, as shown in Figs. 22 and 23.
Fig. 22 is a schematic perspective view of such an embodiment of the present apparatus 70 wherein a part of the side wall of the housing is cut away, and Fig. 23 is a schematic sectional view thereof. The present apparatus 70 of the embodiment as shown in Figs. 22 and 23 comprises the housing 71 containing the inlet opening 72 for the gas G to be treated 72 and the outlet opening 73 for the treated gas C 73. The housing 71 contains therein the solid-cylindrical protected electrodes 76A belonging to the first electrodes-groups and the exposed plate electrodes 75B belonging to the second electrodes-groups. The solid-cylindrical protected electrode 76A contains the inner bar electrode 76X and the insulating coating layer 76Y.

The insulating coating layer 76Y is carried on the surface of the inner bar electrode 76X in such a manner that the insulating coating layer 76Y is in close contact with the inner bar electrode 76X and covers the entire surface of the inner bar electrode 76X. Therefore, there is no space between the inner bar electrode 76X and the insulating coating layer 76Y. The gas to be treated is brought into contact with the insulating coating layer 76Y, but is not brought into contact with the inner bar electrode 76X. The solid-cylindrical protected electrodes 76A are connected with the wire (not shown), respectively, the exposed plate electrodes 75B are connected with the wire (not shown), respectively, and each wire is connected with the AC source (not shown). It is not necessary to ground the wire and the housing. However, one or both of the wire and the housing may be grounded. In the embodiment shown in Figs. 22 and 23, the housing 71 is grounded.

When the gas G to be treated is introduced into the inlet opening 72 of the air-treating apparatus of the present invention 70 as shown in Figs. 22 and 23, the gas G to be treated is passed between the openings in each of the exposed plate electrodes 758, and between each of the solid-cylindrical protected electrodes 76A, and eventually discharged from the outlet opening 73. During the passage, a voltage is applied between the solid-cylindrical protected electrodes 76A and the exposed plate electrodes 75B to cause a discharge between the solid-cylindrical protected electrodes 76A and the exposed plate electrodes 75B, whereby gas molecules are excited and radicals are generated. The radicals oxidize and decompose malodorous substances in the gas to be treated and generate ozone so that the gas to be treated is oxidized. If the gas to be treated is discharged from the outlet opening 73 together with the generated radicals and ozone, and conveyed to a catalyst chamber (not shown) filled with oxidizing catalysts, a reaction of the radicals and ozone with the gas to be treated can be further carried out to continue the treatment of the gas.

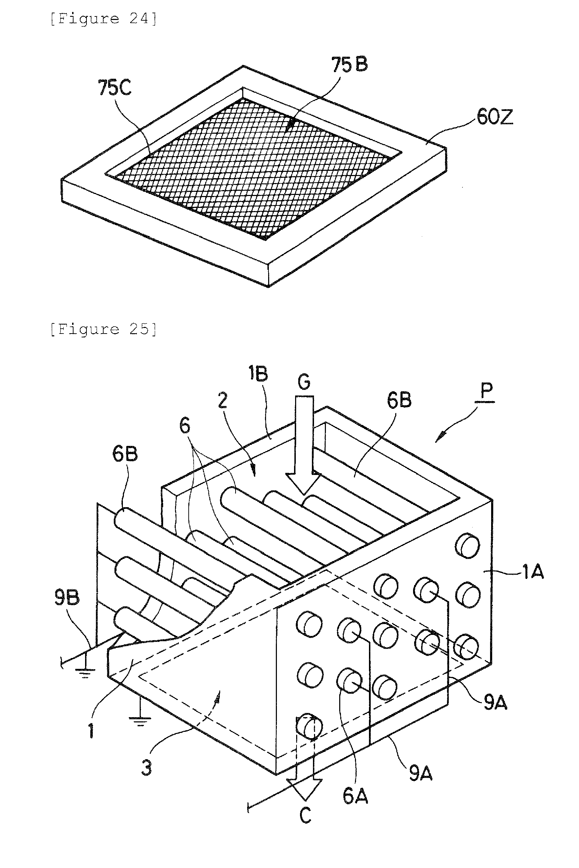

When the housing 71 in the air-treating apparatus 70 of the present invention as shown in Figs. 22 and 23 is not grounded, a surface discharge on the surface of the wall holding the solid-cylindrical protected electrodes 76A in the housing 71 may be prevented, for example, as shown in Fig. 24, by fixing the exposed plate electrodes 75B on the housing (not shown) via the sheaths 60Z of an insulating material arranged around the exposed plate electrode 75B to surround it and substantially extend the distance capable of allowing a surface discharge between the exposed end 75C of the exposed plate electrode 75B and the adjacent hollow-cylindrical protected electrode 76A.

In the air-treating apparatus 70 of the present invention as shown in Figs. 22 and 23, a protected through-holes plate electrode may be used instead of the exposed through-holes-plate electrode 75B. The protected through-holes plate electrode contains the through-holes plate inner electrode and the insulating coating layer. The insulating coating layer is carried on the surface of the through-holes plate inner electrode in such a manner that the insulating coating layer is in close contact with the through-holes plate inner electrode and covers the entire surface of the through-holes plate inner electrode, while the condition of the through-holes capable of passing the gas to be treated is maintained. There is no space between the through-holes plate inner electrode and the insulating coating layer. Further, the gas to be treated is brought into contact with the insulating coating layer, but not with the through-holes plate inner electrode. The protected through-holes-plate electrode may be used in combination with the hollow- or solid-cylindrical protected or exposed electrodes.

In the gas-exciting apparatus according to the present invention, any components used in the conventional gas-exciting apparatus, for example, the apparatuses disclosed in Japanese Unexamined Patent Publication (Kokai) No. 9-199261 or U.S. Patent No. 5,483,117, can be used, as they are, other than the protected plate electrode, the exposed plate electrode, and the hollow/solid-cylindrical exposed electrode as above.

### INDUSTRIAL APPLICABILITY

The present invention may be applied to, for example, a deodorizing apparatus or an air cleaning apparatus, by guiding gas under the condition of an AC high-pressure discharge to excite gas molecules and generate a low-temperature plasma.
Although the present invention has been described with reference to specific embodiments, various changes and modifications obvious to those skilled in the art are possible without departing from the scope of the appended claims.

## Claims

1. An apparatus for exciting a gas, comprising at least one pair of electrodes connecting with an alternate current electric source in a housing having an inlet opening for the gas to be treated and an outlet opening for a treated gas, the pair being a combination of a protected electrode with a protected electrode, or a combination of a protected electrode and an exposed electrode, wherein at least one protected electrode is composed of a core electrode and an insulating coating layer carried thereon and covering an entire surface thereof.

2. The apparatus for exciting a gas according to claim 1, wherein the insulating coating layer is a porcelain enameled coating layer, a ceramic coating layer, a glass coating layer, or a resin coating layer.

3. The apparatus for exciting a gas according to claim 1 or 2, wherein the apparatus comprises a first electrodes-group composed of plural protected electrodes and a second electrodes-group composed of plural protected or exposed electrodes, and at least one of the protected electrodes belonging to the first electrodes-group and/or the protected electrodes belonging to the second electrodes-group is the protected electrode containing the insulating coating layer.

4. The apparatus for exciting a gas according to claim 3, wherein all of the protected electrodes are the protected electrode containing the insulating coating layer.

5. The apparatus for exciting a gas according to any of claims 1 to 4, wherein the core electrode carrying the insulating coating layer thereon in the protected electrode is a solid-cylindrical form, a hollow-cylindrical form, or a plate form.

6. The apparatus for exciting a gas according to claim 5, wherein the inner plate electrode is a plate electrode, a concave-convex plate electrode, or a perforated plate electrode.

7. A process for exciting a gas, comprising passing the gas to be treated into a housing containing at least one pair of electrodes and having an inlet opening for the gas to be treated and an outlet opening for a treated gas, the pair being a combination of a protected electrode and a protected electrode, or a combination of a protected electrode and an exposed electrode, and applying an alternating-current potential between the pair of electrodes to excite the gas to be treated, wherein at least one protected electrode is composed of a core electrode with an insulating coating layer carried thereon and covering an entire surface thereof.

8. The process for exciting a gas according to claim 7, wherein the insulating coating layer is a porcelain enameled coating layer, a ceramic coating layer, a glass coating layer, or a resin coating layer.

9. The process for exciting a gas according to claim 7 or 8, wherein the apparatus comprises a first electrodes-group composed of plural protected electrodes and a second electrodes-group composed of plural protected or exposed electrodes, and at least one of the protected electrodes belonging to the first electrodes-group and/or the protected electrodes belonging to the second electrodes-group is the protected electrode containing the insulating coating layer.

10. The process for exciting a gas according to claim 9, wherein all of the protected electrodes are the protected electrode containing the insulating coating layer.

11. The process for exciting a gas according to any of claims 7 to 10, wherein the core electrode carrying the insulating coating layer thereon in the protected electrode is a solid-cylindrical form, a hollow-cylindrical form, or a plate form.

12. The process for exciting a gas according to claim 11, wherein the inner plate electrode is a plate electrode, a concave-convex plate electrode, or a perforated plate electrode.
